# FASCICULE DE BREVET EUROPEEN

(11) **EP 2 850 658 B1**
(45) Date de publication et mention de la délivrance du brevet: **30.11.2022**
(21) Numéro de dépôt: 13722409.3
(22) Date de dépôt: 13.05.2013
(51) Int. Cl.: H01L 25/16, H01L 23/373, H01L 23/498

(54) **AGENCEMENT DE MODULE ÉLECTRIQUE DE PUISSANCE**
ANORDNUNG EINES ELEKTRISCHEN LEISTUNGSMODULS
ELECTRIC POWER MODULE ARRANGEMENT

(30) Priorité: 16.05.2012 FR 1254521
(43) Date de publication de la demande: 25.03.2015
(73) Titulaire: Safran Electronics & Defense, 92100 Boulogne-Billancourt (FR)
(72) Inventeur: ROCHE, Olivier, 77550 Moissy-Cramayel (FR)
(74) Mandataire: Lavialle, Bruno François Stéphane
(86) Numéro de dépôt international: PCT/EP2013/059762
(87) Numéro de publication internationale: WO 2013/171136

(56) Documents cités:
- EP-A2- 0 547 877
- WO-A1-2004/002204
- DE-A1- 3 930 858
- DE-A1- 4 034 674
- DE-A1-102006 051 454
- DE-A1-102008 025 705
- DE-U1- 9 403 108
- FR-A1- 2 816 462
- US-A1- 2008 217 756
- US-A1- 2009 140 399
- US-A1- 2009 261 472
- US-A1- 2011 069 458

## Description

L'invention concerne un module électrique de puissance destiné à être utilisé dans une application de type aéronautique en étant accolé à l'actionneur qu'il pilote, ce qui nécessite une fiabilité élevée dans un environnement sévère, ainsi qu'une masse et un volume réduits.

### ARRIERE PLAN DE L'INVENTION

Un tel module onduleur est destiné à être interposé entre une source électrique et un actionneur électromécanique, pour injecter dans les moteurs électriques de l'actionneur un signal électrique de puissance ayant une fréquence qui dépend d'une commande adressée au module et qui varie dans le temps.

Ce type de module est par exemple utilisé pour déplacer un volet ou autre élément aérodynamique de l'aéronef selon une commande et des conditions de fonctionnement pouvant varier continuellement.

En pratique, un tel module reçoit des instructions de commande, et il ajuste en fonction de celles-ci, la fréquence du signal de puissance qu'il délivre à l'actionneur ainsi que d'autres paramètres de ce signal de puissance.

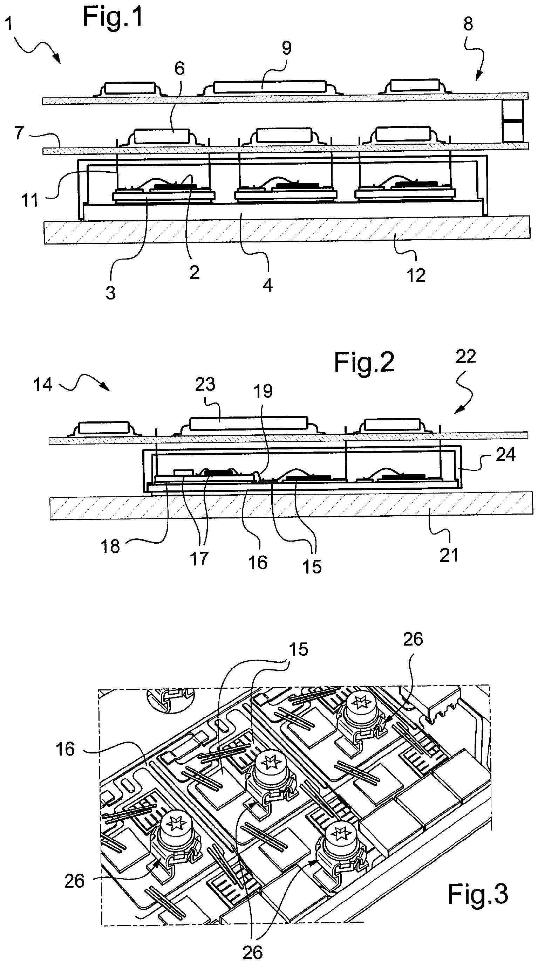

Un tel module, dont une partie est représentée schématiquement en coupe dans la figure 1 en y étant repéré par 1, comporte des transistors de puissance 2 portés par des substrats de puissance 3 qui sont eux-même portés par une semelle en cuivre 4 pour dissiper la chaleur produite par les transistors de puissance. Il comporte encore des composants de commande 6 pilotant les transistors de puissance en étant portés par un autre substrat 7, ainsi qu'une carte d'interface 8 comportant d'autres composants 9.

Comme visible dans la figure 1, le substrat 7 portant les composants de commande 6 est situé au dessus de l'ensemble formé par les substrats de puissance 3 et la semelle 4 qui les porte, tout en étant espacé de cet ensemble, ce qui permet de réduire les longueurs des connexions 11 reliant les composants de commande aux transistors de puissance 2.

Les substrats de puissance 3 qui sont généralement du type DBC/Al2O3 (qui est un acronyme signifiant "Direct Bonded Copper / Aluminium Oxyde" se traduisant par Cuivre Fixé Directement sur Oxyde d'Aluminium) comportent à leurs faces supérieures des pistes de cuivre recevant les transistors de puissance 2, et leurs faces inférieures sont recouvertes de cuivre.

Chaque substrat de puissance 3 est solidarisé à la semelle de cuivre 4 en étant brasé à la face supérieure de celle-ci, et cette semelle en cuivre 2 a sa face opposée qui est accolée à une structure porteuse constituant un radiateur refroidissant le module 1 par conduction lorsque l'ensemble est en place, les parties les plus chaudes de ce module étant ses transistors de puissance.

Le document EP0547877 décrit un module comportant une semelle en cuivre portant un substrat composite comprenant un substrat principal ayant à sa face supérieure des pistes métalliques portant des composants de puissance, ainsi qu'un second substrat en céramique sur lequel sont montés des composants de commande pilotant les composants de puissance.

Le document US 2011/069458 décrit un module de puissance comprenant une base métallique portant des circuits imprimés incluant chacun un substrat céramique portant des conducteurs à ses faces opposées et portant en face supérieure des composants de puissance. Le module porte des électrodes en tôle présentant des portions supérieures repliées pour renfermer des porte écrous destinés à recevoir des écrous.

Le document US 2008/217756 décrit un module semiconducteur de puissance refroidi par conduction thermique. Le module comprend un substrat principal de type AMB/Si3N4 portant des composants semi-conducteurs de puissance. Le substrat principal est en contact avec un dissipateur thermique via une couche ayant une bonne conductivité thermique.

### OBJET DE L'INVENTION

Le but de l'invention est de proposer une structure de module électrique de puissance ayant une fiabilité, une compacité et une masse plus satisfaisantes que celles des modules connus.

### RESUME DE L'INVENTION

A cet effet, l'invention a pour objet un module électrique de puissance selon la revendication 1, comportant des transistors de puissance, ainsi que des composants de commande pour piloter ces transistors de puissance, ce module étant adapté pour être refroidi par conduction thermique. Selon l'invention, le module comporte
- un substrat principal du type AMB/Si3N4 portant les transistors de puissance, ce substrat principal constituant en soi une semelle de dissipation thermique de la chaleur générée par les transistors de puissance en étant agencé dans le module pour être directement en contact avec une structure porteuse assurant le refroidissement par conduction lorsque ce module est monté ;
- un substrat en céramique portant les composants de commande, ce substrat en céramique étant lui-même porté par le substrat principal ;
- des plots de connexion de puissance se présentant chacun sous forme d'une tôle conductrice découpée et pliée autour d'une région centrale pour emprisonner un écrou de serrage agencé sous la région centrale de la tôle incluant un orifice central, chaque plot étant fixé au substrat principal par soudage d'une ou plusieurs extrémités de la tôle pliée qui le constitue à une piste de ce substrat, chaque écrou étant agencé pour recevoir une vis de fixation d'un organe d'alimentation en puissance au plot,
la tôle comportant des premières languettes rabattues dans une même direction de manière à délimiter avec le reste de la tôle une cage immobilisant l'écrou,
et la tôle comportant des deuxièmes languettes rabattues dans une direction opposée à celle des premières languettes de manière à dépasser de la région centrale de la tôle pour maintenir en position une extrémité de patte de connexion de l'organe d'alimentation en puissance.

Avec cet agencement, une semelle en cuivre additionnelle n'est plus nécessaire du fait que la dissipation de chaleur est assurée directement par le substrat portant l'ensemble des transistors de puissance. Le nombre de composants du module est ainsi réduit, ce qui permet d'accroître sa fiabilité, et de réduire sa masse ainsi que son encombrement.

L'invention concerne également un module tel que défini ci-dessus, dans lequel les pistes du substrat principal et les pistes du substrat en céramique porté par ce substrat principal sont reliées les unes aux autres par des fils ayant chacun une extrémité soudée à une piste du substrat principal et une autre extrémité soudée à une piste du substrat en céramique.

L'invention concerne également un module tel que défini ci-dessus, dans lequel le substrat en céramique est du type alumine couche épaisse.

L'invention concerne également un module tel que défini ci-dessus, comportant en outre un bus de puissance sous forme d'une pièce lamelée en couches de cuivre et de kapton comportant des bornes sous forme de perçages, le bus étant fixé au reste du module grâce à des vis de fixation traversant ledit bus au niveau des bornes et vissées dans les plots.

L'invention concerne également un module comprenant un bus de puissance tel que défini ci-dessus, un châssis métallique fermé par le bus de puissance, et dans lequel le bus de puissance comporte une couche de cuivre qui est en appui sur le châssis lorsque le bus est fixé audit châssis, de manière à constituer avec ce châssis une cage de Faraday.

### BREVE DESCRIPTION DES FIGURES

La figure 1 déjà décrite est une vue en coupe schématique partielle d'un agencement de module connu de l'Etat de la technique ;
La figure 2 est une vue en coupe schématique partielle de l'agencement selon l'invention ;
La figure 3 est une vue montrant les plots de connexion de puissance portés par le substrat principal du module selon l'invention ;
La figure 4 est une vue montrant les plots de connexion de puissance connectés au bus de puissance du module selon l'invention ;
La figure 5 est une vue en perspective de dessus d'un plot de connexion de puissance du module selon l'invention ;
La figure 6 est une vue en perspective de dessous d'un plot de connexion de puissance du module selon l'invention ;
La figure 7 est une vue de dessus du bus de puissance du module de puissance selon l'invention ;
La figure 8 est une vue en éclaté du bus de puissance du module selon l'invention qui montre les couches constitutives de son empilement ;
La figure 9 est une vue montrant en perspective le bus de puissance du module selon l'invention.

### DESCRIPTION DETAILLEE DE L'INVENTION

L'idée à la base de l'invention est de rassembler les transistors de puissance sur un unique substrat principal unique approprié, pour se dispenser d'une semelle de dissipation additionnelle. Ceci permet de réduire les dimensions et la masse de l'ensemble tout en éliminant les aléas de fiabilité introduits par la brasure des substrats de puissance sur la semelle en cuivre.

En effet, ces brasures constituent une source de défaillance des modules connus du fait des dilatations différentielles auxquelles ces modules sont soumis, et qui sollicitent mécaniquement ces brasures au point de les fissurer, voire de les détruire.

Plus concrètement, selon l'invention, le substrat principal supportant les transistors de puissance est un substrat unique du type AMB/Si3N4, qui est un acronyme signifiant "Active Metal Bonding / Silicon Nitride", c'est-à-dire Fixation Active du Métal sur Nitrure de Silicium. Un substrat de ce type possède des caractéristiques mécaniques et thermiques lui conférant une tenue mécanique et thermique accrue au fil des cycles de fonctionnement, de sorte qu'il peut également constituer la semelle de dissipation thermique sans risque de détérioration.

Dans le module selon l'invention qui est représenté schématiquement en figure 2, en y étant repéré par 14, les différents transistors de puissance 15 constituant le pont de puissance du module sont portés par un même substrat principal 16, de type AMB/Si3N4, qui comporte des pistes de cuivre à sa face supérieure, et dont la face inférieure est également en cuivre.

Pour améliorer encore la compacité, les composants de commande 17 et leurs alimentations associées, qui pilotent les transistors de puissance 15, ainsi que des sondes de température, sont portés par un substrat en céramique 18, qui est lui-même porté directement par le substrat principal 16 en étant collé à celui-ci.

Avantageusement, le substrat en céramique 18 est du type alumine couche épaisse, pour présenter une bonne conductivité thermique de façon à faciliter une évacuation efficace de la chaleur produite par les composants de commande.

L'ensemble les transistors de puissance et les composants qui les commandent sont ainsi regroupés sur un même support général constitué par le substrat principal 16 qui joue également le rôle de semelle de dissipation thermique.

Comme visible dans la figure 2, les composants de commande 17 sont reliés aux transistors de puissance 15 par des câbles soudés 19 qui relient les pistes situées en face supérieure du substrat en céramique 18, aux pistes situées en face supérieure du substrat principal 15.

Tout comme dans l'Etat de la technique, chaque transistor de puissance 15 est relié à une piste du substrat de puissance 16 en étant directement soudé à cette piste, et il est relié à une autre piste de la face supérieure de ce substrat par un câble soudé à une face supérieure du transistor et à la piste en question, les transistors de puissance utilisés étant des transistors dépourvus de boîtier de protection.

Comme visible dans la figure 2, le substrat principal 16 est directement rapporté contre la structure porteuse 21 formant radiateur lorsque le module selon l'invention est monté, de manière à refroidir efficacement les transistors de puissance. Autrement dit, le substrat principal à la base de l'assemblage selon l'invention constitue également la semelle de dissipation thermique du module.

Et de plus, les composants de commande portés par le substrat céramique sont physiquement très proches des transistors de puissance qu'ils commandent, ce qui confère un meilleur comportement fonctionnel du système.

Au dessus de l'ensemble constitué par le substrat de puissance 16 avec les différents éléments qu'il porte, à savoir les transistors de puissance, le substrat en céramique et les composants de commande, peut être placée une carte d'interface 22 portant d'autres composants 23. Cette carte d'interface 22 est alors espacée de l'ensemble constitué par le substrat principal 16 avec les éléments qu'il porte, en s'étendant parallèlement à cet ensemble.

Complémentairement, un cadre métallique 24 collé au substrat de puissance permet la fixation du substrat avec ses éléments à la carte d'interface 22 en délimitant un espace interne renfermant les transistors de puissance ainsi que leurs organes de commande. Cette cavité interne est avantageusement remplie d'un gel de protection de l'électronique.

Comme indiqué plus haut, le module électrique est soumis à des variations thermiques cycliques qui sont importantes, donnant lieu à des dilatations différentielles susceptibles de solliciter mécaniquement ses composants au point de les détériorer.

Dans ce cadre, le module selon l'invention est équipé de plots de connexion de puissance 26 portés par son substrat principal 16 pour alimenter en puissance le module, et via lesquels celui-ci délivre son signal de puissance. Selon l'invention, ces plots sont conçus pour présenter une certaine flexibilité afin de mieux supporter les effets de la dilatation différentielle.

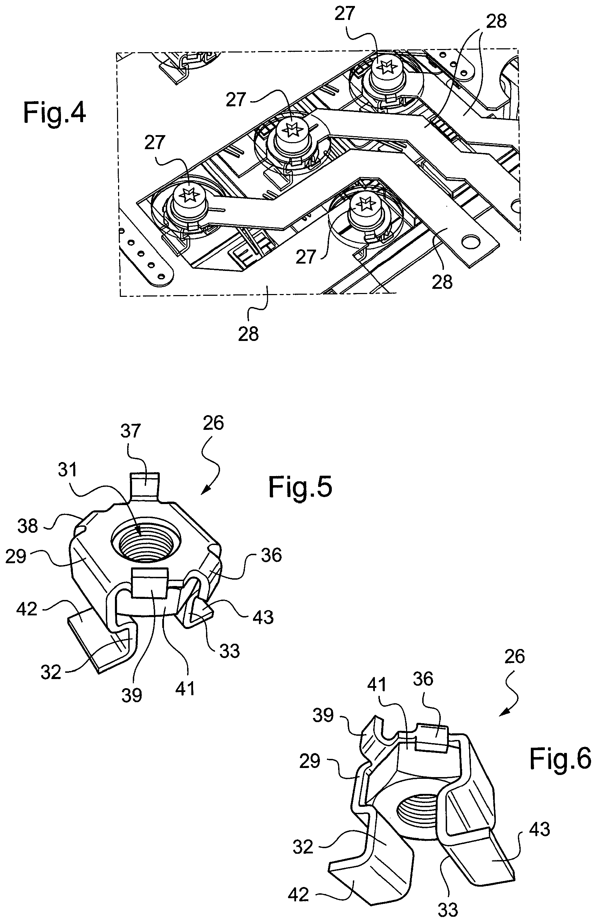

Comme visible en figure 5, chaque plot 26 comporte un élément de tôle découpée et pliée pour d'une part emprisonner un écrou, et d'autre part délimiter deux pattes terminales repliées de façon à être coplanaires pour permettre sa fixation par brasage à une piste du substrat 16.

Une fois en place, c'est-à-dire une fois brasé sur le substrat principal 16, chaque plot de connexion 26 reçoit une vis 27 s'engageant dans le filet de l'écrou qu'il renferme pour assurer la fixation d'une patte de connexion électrique de puissance, ces pattes étant repérées par 28 dans la figure 6.

Comme visible dans les figures 5 et 6, les différents plots 26 qui sont identiques, ont leurs faces supérieures toutes au même niveau une fois qu'ils ont été brasés sur le substrat principal 16, ce qui maintient un espace entre les pattes de connexion 28 et le substrat principal 16, lorsque l'ensemble est monté.

Comme on l'aura compris, la fixation d'une patte 28 à un plot 26 est assurée par une vis 27 qui traverse un trou réalisé en extrémité de patte, et qui s'engage dans un plot 26 de manière à enserrer fermement cette extrémité de patte de connexion 26 entre la tête de vis 27 et le corps du plot 26.

Chaque plot 26 est fabriqué à partir d'une bande de tôle de cuivre 29 découpée pour délimiter un contour généralement rectangulaire et pour comporter un orifice central 31 situé entre deux pattes principales 32 et 33 qui s'étendent dans le prolongement l'une de l'autre et qui correspondent aux extrémités principales du contour rectangulaire.

Cette tôle découpée 29 comporte encore quatre languettes 36, 37, 38 et 39 s'étendant radialement vers l'extérieur par rapport à la région centrale que définit l'orifice 31. Comme visible dans les figures, les deux pattes principales et les quatre languettes sont espacées les unes des autres de soixante degrés autour de l'orifice central 31.

Les pattes principales 32 et 33 de cette tôle 29 sont rabattues vers le bas de manière à renfermer un écrou hexagonal 41 en l'emprisonnant. Complémentairement, les extrémités libres 42 et 43 de ces pattes 32 et 33 sont repliées vers l'extérieur de façon à être coplanaires pour permettre de les braser à une piste de cuivre du substrat principal 16.

Complémentairement, les languettes 36 et 38 sont aussi rabattues vers le bas de manière à délimiter avec le reste de la tôle 29 une cage immobilisant complètement l'écrou 41, et les languettes 37 et 39 sont rabattues en direction opposée, de manière à dépasser de la face supérieure du plot 26 afin de maintenir en position l'extrémité de patte de connexion 28 que le plot est destiné à recevoir.

De par leur structure générale, ces plots 26 fabriqués en tôle de cuivre pliée présentent une flexibilité grâce à laquelle les dilatations différentielles que subit le module ne risquent pas d'endommager ce module ni ses connexions : chaque plot fléchit de manière significative en cas de dilatation différentielle, ce qui a pour effet de diminuer d'autant les contraintes mécaniques induites dans les composants du module.

En particulier, chaque plot 26 présente une flexibilité importante selon une direction privilégiée correspondant à un axe normal au corps des pattes 32 et 33 rabattues.

Le module selon l'invention comporte encore un bus de transmission de puissance, raccordé aux plots 26 par les vis 27, et qui constitue également un capot fermant le corps ou châssis du module 14 non visible dans les figures.

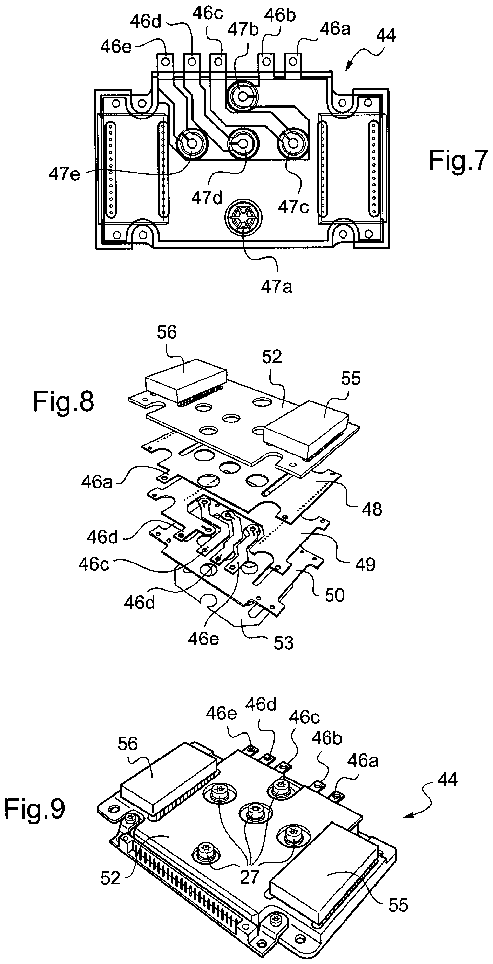

Ce bus de puissance qui est représenté en figure 8 et 9 en y étant repéré par 44 est celui par lequel transitent les forts courant électrique d'alimentation du module et les forts courants électriques que le module fournit à l'actionneur qu'il pilote.

Selon l'invention, ce bus de transmission de puissance qui a une forme généralement plane délimitée par un contour rectangulaire, est fabriqué sous forme d'un élément laminé formant un empilement de couches de cuivre et de couches de kapton formant isolants.

Il comporte cinq languettes de connexion externes dépassant de l'un de ses bords longitudinaux, repérées 46a à 46e, qui sont électriquement reliées à cinq bornes correspondantes 47a à 47e situées en région centrale du bus 44 et se présentant sous forme de perçages traversants à couronne externe conductrice.

La languette 46a est reliée à la borne 47a par la patte 28 dont elle fait partie, et de manière analogue, les languettes 46b, 46c, 46d, 46e sont électriquement reliées respectivement aux bornes 47b, 47c, 47d et 47e par des pattes 28 distinctes.

Ces connexions électriques dans le bus 44 sont assurées par un empilement d'éléments comportant trois couches de cuivres 48, 49 et 50 représentées en figure 8 et qui sont isolées les unes des autres par des couches de kapton non représentées. Complémentairement, deux couches additionnelles 52 et 53 sont rapportées en face supérieure et en face inférieure du bus 44, comme visible aux figures 8 et 9.

La couche de cuivre supérieure 48 se présente sous forme d'une plaque présentant quatre perçages de grand diamètre au niveau des bornes 47b à 47e. Elle comporte un plus petit perçage au niveau de la borne 47a pour former cette borne, et elle comporte également la languette 46a qu'elle raccorde ainsi électriquement à la borne 47a.

La couche de cuivre médiane 49 comporte quatre éléments de cuivre distincts qui délimitent les languettes 46b à 46e et les bornes 47b à 47e. Comme on l'aura compris, chacun de ces quatre éléments constitue l'une des quatre pattes 28 de la figure 4. Autrement dit, ces quatre éléments relient respectivement les languettes 46b à 46e aux bornes 47b à 47e en étant disposés de manière à être électriquement isolés les uns des autres. Chaque borne 47b à 47e est définie dans l'un de ces éléments sous forme d'un perçage de relativement faible diamètre. En outre, l'élément qui passe au niveau de la borne 47a présente au niveau de cette borne un perçage de grand diamètre, non visible dans la figure 8.

La couche inférieure 50 se présente sous forme d'une plaque de cuivre unique délimitée par un contour généralement rectangulaire, et elle vient en appui sur le châssis du module lorsque le bus 44 est fixé à ce châssis, de sorte qu'elle délimite avec le châssis du module une cage de Faraday, c'est-à-dire une cage qui isole les composants internes du module des perturbations électromagnétiques externes.

Comme on l'aura compris, cette couche de cuivre inférieure 50 comporte cinq perçages de grand diamètre, au niveau des bornes 47a à 47e.

Comme visible dans la figure 8 la couche inférieure d'isolant 53 a des dimensions sensiblement inférieures à celles de la plaque 50, de manière à ce que le pourtour de cette plaque soit dégagé pour être en contact électrique avec le châssis du module lorsque l'ensemble est monté.

Deux couches additionnelles de kapton sont interposées entre les couches 48 et 49 d'une part, et entre les couches 49 et 50 d'autre part, de sorte que ces couches sont complètement isolées électriquement les unes des autres.

Complémentairement, ce bus de puissance 44 porte deux condensateurs, repérés par 55 et 56, montés sur la couche d'isolant supérieur 52, chacun de ces condensateurs étant relié d'une part à la couche de cuivre supérieure 48, et d'autre part à l'élément de la couche médiane 49 qui relie la languette 46b à la borne 47b.

Comme visible dans la figure 9, une fois que le bus 44 a été monté sur le châssis du module selon l'invention qu'il équipe, les vis 27 traversent ce bus au niveau de chacune des bornes 47a à 47e pour être serrées dans les plots flexibles 26 qui sont portés par le substrat principal 16. Ce bus assure ainsi conjointement la fermeture du châssis ou boîtier du module, la constitution d'une cage de Faraday apportant une isolation électromagnétique à l'onduleur, et la connexion aux moyens d'alimentation et à l'actionneur grâce aux languettes 46a à 46e.

## Revendications

1. Module électrique de puissance (14), comportant des transistors de puissance (15), ainsi que des composants de commande (17) pour piloter ces transistors de puissance (15), ce module (14) étant adapté pour être refroidi par conduction thermique et comportant :
- un substrat principal (16) du type AMB/Si3N4 portant les transistors de puissance (15), ce substrat principal (16) constituant en soi une semelle de dissipation thermique de la chaleur générée par les transistors de puissance (15) en étant agencé dans le module (14) pour être directement en contact avec une structure porteuse (21) assurant le refroidissement par conduction lorsque ce module (24) est monté ;
- un substrat en céramique (18) portant les composants de commande (17), ce substrat en céramique (18) étant lui-même porté par le substrat principal (16) ;
- des plots de connexion de puissance (26) se présentant chacun sous forme d'une tôle (29) conductrice découpée et pliée autour d'une région centrale pour emprisonner un écrou de serrage (41) agencé sous la région centrale de la tôle incluant un orifice central (31), chaque plot (26) étant fixé au substrat principal (16) par soudage d'une ou plusieurs extrémités de la tôle pliée qui le constitue à une piste de ce substrat, chaque écrou (41) étant agencé pour recevoir une vis de fixation d'un organe d'alimentation en puissance au plot,
la tôle (29) comportant des premières languettes (36, 38) rabattues dans une même direction de manière à délimiter avec le reste de la tôle une cage immobilisant l'écrou (41),
et la tôle (29) comportant des deuxièmes languettes (37, 39) rabattues dans une direction opposée à celle des premières languettes (36, 38) de manière à dépasser de la région centrale de la tôle pour maintenir en position une extrémité d'une patte de connexion (28) de l'organe d'alimentation en puissance.

2. Module selon la revendication 1, dans lequel les pistes du substrat principal (16) et les pistes du substrat en céramique (18) porté par ce substrat principal (16) sont reliées les unes aux autres par des fils (19) ayant chacun une extrémité soudée à une piste du substrat principal (16) et une autre extrémité soudée à une piste du substrat en céramique (18).

3. Module selon la revendication 1, dans lequel le substrat en céramique (18) est du type alumine couche épaisse.

4. Module selon la revendication 1, comportant en outre un organe d'alimentation en puissance constituant un bus de puissance (44) sous forme d'une pièce lamellée en couches de cuivre et de kapton comportant des bornes (47a-47e) sous forme de perçages, le bus étant fixé au reste du module grâce à des vis de fixation (27) traversant ledit bus au niveau des bornes et vissées dans les plots (26).

5. Module selon la revendication 4, comportant un châssis métallique fermé par le bus de puissance (44), et dans lequel le bus de puissance (44) comporte une couche de cuivre (50) qui est en appui sur le châssis lorsque le bus (44) est fixé audit châssis, de manière à constituer avec ce châssis une cage de Faraday.

## Patentansprüche

1. Elektrisches Leistungsmodul (14), umfassend Leistungstransistoren (15), sowie Steuerkomponenten (17) zum Steuern dieser Leistungstransistoren (15), wobei dieses Modul (14) angepasst ist, durch Wärmeleitung gekühlt zu werden, und umfasst:
- ein Hauptsubstrat (16) vom Typ AMB/Si3N4, das die Leistungstransistoren (15) trägt, wobei dieses Hauptsubstrat (16) selbst eine wärmeableitenden Grundplatte zur Ableitung der Wärme bildet, die von den Leistungstransistoren (15) erzeugt wird, indem es in dem Modul (14) angeordnet ist, um direkt in Kontakt mit einer Trägerstruktur (21) zu sein, die das Kühlen durch Leitung sicherstellt, wenn dieses Modul (24) montiert ist;
- ein Keramiksubstrat (18), das die Steuerkomponenten (17) trägt, wobei dieses Keramiksubstrat (18) selbst von dem Hauptsubstrat (16) getragen wird;
- Leistungsverbindungskontakte (26), die sich jeweils in Form eines leitenden Blechs (29) präsentieren, das ausgeschnitten und um einen zentralen Bereich gebogen ist, um eine Spannmutter (41) einzuschließen, die unter dem zentralen Bereich des Blechs, das eine zentrale Öffnung (31) enthält, angeordnet ist, wobei jeder Kontakt (26) am Hauptsubstrat (16) durch Schweißen eines oder mehrerer Enden des gebogenen Blechs, aus dem er gebildet ist, an eine Bahn dieses Substrats befestigt ist, wobei jede Mutter (41) ausgebildet ist, eine Befestigungsschraube zur Befestigung eines Leistungsversorgungsorgans am Kontakt aufzunehmen,
wobei das Blech (29) erste Zungen (36, 38) umfasst, die in eine selbe Richtung umgelegt sind, um mit dem Rest des Blechs einen Käfig zu begrenzen, der die Mutter (41) fixiert,
und das Blech (29) zweite Zungen (37, 39) umfasst, die in eine Richtung entgegengesetzt zu der der ersten Zungen (36, 38) umgelegt sind, um über den zentralen Bereich des Blechs hinauszugehen, um ein Ende einer Verbindungslasche (28) des Leistungsversorgungsorgans in Position zu halten.

2. Modul nach Anspruch 1, bei dem die Bahnen des Hauptsubstrats (16) und die Bahnen des Keramiksubstrats (18), das von diesem Hauptsubstrat (16) getragen wird, miteinander über Drähte (19) verbunden sind, die jeweils ein Ende haben, das an eine Bahn des Hauptsubstrats (16) geschweißt ist, und ein anderes Ende, das an eine Bahn des Keramiksubstrats (18) geschweißt ist.

3. Modul nach Anspruch 1, bei dem das Keramiksubstrat (18) vom Typ Dickschicht-Aluminiumoxid ist.

4. Modul nach Anspruch 1, ferner umfassend ein Leistungsversorgungsorgan, das einen Leistungsbus (44) in Form eines Schichtteils aus Kupfer- und Kaptonschichten bildet, das Klemmen (47a-47e) in Form von Bohrungen umfasst, wobei der Bus am Rest des Moduls mittels Befestigungsschrauben (27) befestigt ist, die den gennannten Bus im Bereich der Klemmen durchsetzen und in die Kontakte (26) geschraubt sind.

5. Modul nach Anspruch 4, umfassend ein Metallgestell, das durch den Leistungsbus (44) geschlossen ist, und bei dem der Leistungsbus (44) eine Kupferschicht (50) umfasst, die an dem Gestell anliegt, wenn der Bus (44) an dem Gestell befestigt ist, um mit diesem Gestell einen faradayschen Käfig zu bilden.

## Claims

1. An electrical power module (14), including power transistors (15), and control components (17) for controlling said power transistors (15), said module (14) being adapted to be cooled by heat conduction, and said module including:
• a main substrate (16) of the AMB/Si₃N₄ type carrying the power transistors (15), this main substrate (16) itself constituting a heat-dissipating baseplate for dissipating the heat generated by the power transistors (15) by being arranged in the module (14) to be directly in contact with the carrier structure (21) that provides cooling by conduction when said module (24) is in place; and
• a ceramic substrate (18) carrying the control components (17), this ceramic substrate (18) itself being carried by the main substrate (16)
• power connection pads (26), each of which is in the form of a strip of conductive metal sheet (29) cut out and folded around a central region to hold a clamping nut (41) captive, the clamping nut being arranged under the central region of the metal sheet including a central orifice (31), each pad (26) being fastened to the main substrate (16) by bonding one or more ends of the folded strip of metal sheet of which it is made to a track of said substrate, each nut (41) being arranged to receive a fastening bolt for fastening a power supply member to the pad,
the metal sheet (29) having first tongues (36, 38) folded back in a same direction so as to co-operate with the remainder of the metal sheet to define a cage that holds the nut (41) completely stationary,
and the metal sheet (29) having second tongues (37, 39) folded back in the direction opposite to that of the first tongues (36, 38) so as to protrude from the central region of the metal sheet in order to hold in position one end of a connection strip (28) of the power supply member.

2. A module according to claim 1, wherein the tracks of the main substrate (16) and the tracks of the ceramic substrate (18) carried by said main substrate (16) are interconnected by wires (19), each of which has one end bonded to a track of the main substrate (16) and another end bonded to a track of the ceramic substrate (18).

3. A module according to claim 1, wherein the ceramic substrate (18) is of the thick-layer alumina type.

4. A module according to claim 1, further including a power supply member constituting a power bus (44) in the form of a laminated part made up of layers of copper and of Kapton and having terminals (47a-47e) in the form of holes, this bus being fastened to the remainder of the module by means of fastening bolts (27) passing through the module while being screwed into the pads (26).

5. A module according to claim 4, including a metal chassis closed by the power bus (44), and wherein the power bus (44) has a layer of copper (50) that is in abutment against the chassis when the bus (44) is in place, in such a manner as to co-operate with the chassis to constitute a Faraday cage.
